# EUROPÄISCHE PATENTSCHRIFT

(11) **EP 2 405 058 B1**
(45) Veröffentlichungstag und Bekanntmachung des Hinweises auf die Patenterteilung: **06.03.2013**
(21) Anmeldenummer: 10450116.8
(22) Anmeldetag: 08.07.2010
(51) Int. Cl.: E01F 9/011, H05K 7/20

(54) **Vorrichtung zur Kühlung eines Schaltschrankes**
Device for cooling a switching cabinet
Dispositif destiné au refroidissement d'une armoire électrique

(43) Veröffentlichungstag der Anmeldung: 11.01.2012
(73) Patentinhaber: Kapsch TrafficCom AG, 1120 Wien (AT)
(72) Erfinder: Spannagl, Peter, 3500 Krems (AT); Hackl, Leopold, 3664 Martingsberg (AT)
(74) Vertreter: Weiser, Andreas

(56) Entgegenhaltungen:
- WO-A1-2007/108765
- WO-A2-2009/049384
- US-A- 6 109 525

## Beschreibung

Die vorliegende Erfindung betrifft eine Vorrichtung zur Kühlung eines Schaltschrankes.

In Schaltschränken entsteht Abwärme, welche abgeführt werden muß, damit eine Überhitzung der darin enthaltenen elektronischen Komponenten vermieden wird. Zur Kühlung von Schaltschränken sind zahlreiche Lösungen bekannt, wie passive Kühlrippen zur Vergrößerung der Abstrahlfläche oder aktive Komponenten wie Ventilatoren, Klimaanlagen usw. Aus der WO 2007/108765 A1 ist es bekannt, einen Schaltschrank in einem hohlen Antennenturm anzuordnen, der einen Lufteinlaß an seinem unteren und einen Luftauslaß an seinem oberen Ende besitzt, wodurch der Schaltschrank durch die im Turm aufsteigende und ihn umströmende Luftströmung gekühlt wird. Diese Kühllösung ist nur bei einer entsprechenden Einbausituation in einem Turm möglich.

Die Erfindung setzt sich zum Ziel, eine Vorrichtung zur Kühlung eines Schaltschrankes zu schaffen, welche ohne aufwendige und energiezehrende aktive Komponenten auskommt und für eine größere Vielfalt von Einbausituationen geeignet ist.

Dieses Ziel wird mit einer Vorrichtung der eingangs genannten Art erreicht, die sich gemäß der Erfindung durch einen hohlen Steher auszeichnet, der einen Lufteinlaß an seinem unteren und einen Luftauslaß an seinem oberen Ende aufweist und den Schaltschrank an seiner Seite trägt, wobei auf Höhe des unteren und des oberen Endes des Schaltschranks jeweils eine Strömungsverbindung zwischen dem Inneren des Schaltschranks und dem Hohlraum des Stehers hergestellt und der Hohlraum des Stehers auf Höhe zwischen den beiden Strömungsverbindungen durch ein Abdichtungselement blockiert ist.

Die Erfindung beruht auf der Erkenntnis, daß Schaltschränke häufig an hohlen Stehern wie Masten, Brückenpfeilern, Trägern usw. montiert werden, deren Hohlraum zur Förderung einer Kühlluftströmung durch den Schaltschrank aufgrund des Kamineffekts, d.h. des Aufsteigens warmer Luft in einem vertikalen Schacht, ausgenützt werden kann. Dazu wird ein Umweg der im Steher aufsteigenden Luftströmung über den Schaltschrank erzwungen, indem zwischen den genannten Strömungsverbindungen zum Schaltschrank der Steherhohlraum blockiert wird. Mit überraschend geringen Mitteln kann auf diese Weise eine wirksame passive Kühlung von Schaltschränken in zahlreichen Einbausituationen erreicht werden.

Bevorzugt ist der Steher ein Stahlsteher einer eine Straße überspannenden Brücke und sein Lufteinlaß eine Kondenswasser-Ablauföffnung am unteren Ende des Stahlstehers. Derartige Kondenswasser-Ablauföffnungen werden bei Stahlstehern in der Regel aus Korrosionsschutzgründen vorgesehen, sodaß sie für die Zwekke der Erfindung in vorteilhafter Weise entsprechend dimensioniert mitverwendet werden können.

Das in den Stehern eingebrachte Abdichtungselement kann grundsätzlich von beliebiger Art sein, beispielsweise ein von einem Ende des Stehers her in diesen eingebrachter Dichtstopfen, eine in den Steher eingeschweißte Trennwand od.dgl. Bevorzugt ist das Abdichtungselement ein in den Hohlraum eingespritzter, aushärtbarer Dichtungsschaum, welcher beispielsweise über eine gesonderte Öffnung in den Steher eingebracht wird.

Falls gewünscht, kann der Schaltschrank zusätzlich mit einem Ventilator zur Zwangskonvektion ausgestattet sein. In gleicher Weise kann der Luftauslaß des Stehers zusätzlich mit einem Abzugsventilator versehen sein.

Die Erfindung wird nachstehend anhand eines in der beigeschlossenen Zeichnung dargestellten Ausführungsbeispiels näher erläutert. In den Zeichnungen zeigt
Fig. 1 einen an einem Steher montierten Schaltschrank in der Perspektivansicht; und
Fig. 2 den Steher und den Schaltschrank von Fig. 1 im Schnitt.

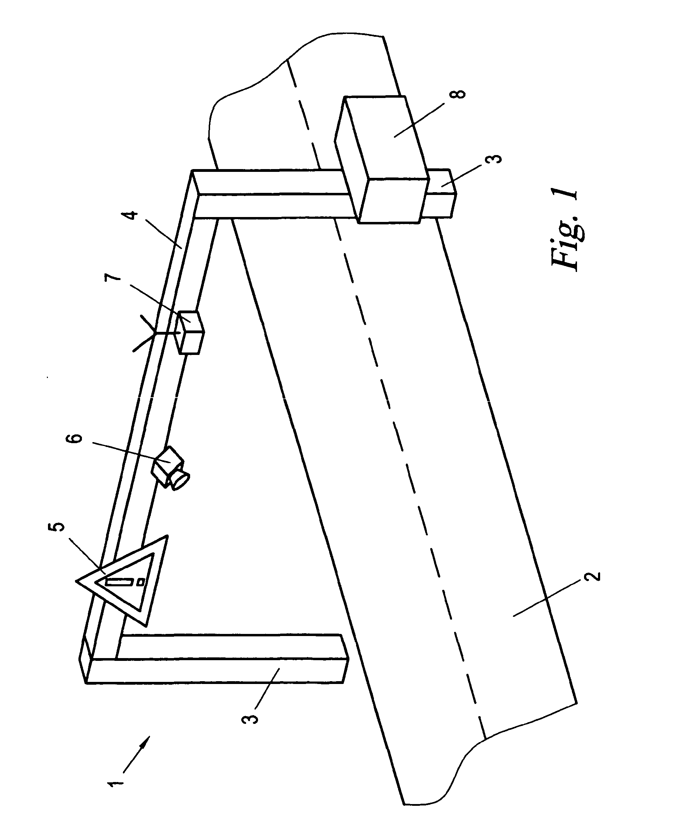

Fig. 1 zeigt eine Brücke 1, welche eine Straße 2 überspannt und aus zwei vertikalen Stehern 3 und einem horizontalen Querträger 4 zusammengesetzt ist. Die Brücke 1 ist beispielsweise eine Montagebrücke für Verkehrszeichen 5, Verkehrsüberwachungskameras oder -scanner 6, Funkbaken 7 zur Funkkommunikation mit Fahrzeugen usw. Zur Aufnahme von Schaltungskomponenten für die Teile 5 - 7 ist an einem der Steher 3 ein Schaltschrank 8 montiert.

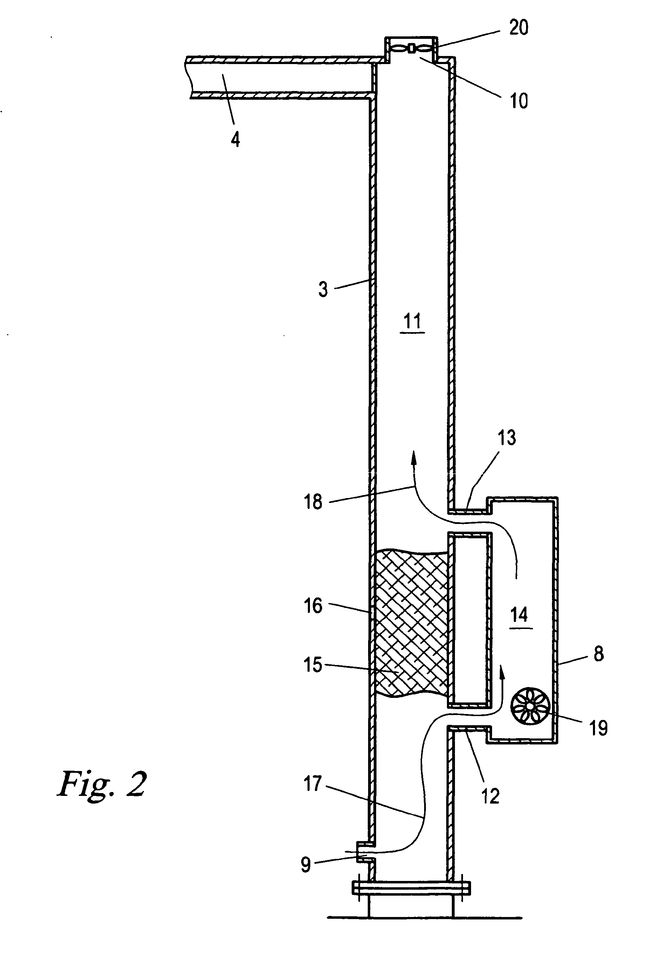

Wie aus Fig. 2 ersichtlich, ist der Steher 3 hohl und an seinem unteren Ende mit einem Lufteinlaß 9 und an seinem oberen Ende mit einem Luftauslaß 10 versehen. Der Lufteinlaß 9 wird beispielsweise durch eine entsprechend dimensionierte Kondenswasser-Ablauföffnung gebildet, wie sie bei Stahlstehern zu Korrosionsschutzzwecken üblicherweise vorgesehen wird.

Durch die Erwärmung der Luftsäule im Hohlraum 11 des Stehers 3 - bzw. auch durch die Erwärmung der Luft im Schaltschrank 8 - stellt sich im Tagesverlauf aufgrund des Kamineffekts eine vertikale Aufwärtsströmung vom Einlaß 9 zum Auslaß 10 ein, welche zur Kühlung des Schaltschranks 8 ausgenützt wird. Zu diesem Zweck wird auf Höhe des unteren und des oberen Endes des Schaltschranks 8 jeweils eine Strömungsverbindung 12, 13 zwischen dem Inneren 14 des Schaltschranks 8 und dem Hohlraum 11 des Stehers 3 hergestellt. Die Strömungsverbindungen 12, 13 können beispielsweise kurze Schlauchstücke sein, die großdurchmeßrige seitliche Öffnungen am Steher 3 einerseits und Schaltschrank 8 andererseits miteinander verbinden, oder der Schaltschrank 8 kann direkt in Anlage am Steher 3 angebracht werden, wobei entsprechend fluchtende Öffnungen in den Seitenwänden des Schaltschranks 8 und Stehers 3 die Strömungsverbindungen 12, 13 bilden.

Zusätzlich wird der Hohlraum 11 des Stehers 3 auf Höhe zwischen den beiden Strömungsverbindungen 12, 13 mittels eines Abdichtungselements 15 unterbrochen bzw. blockiert. Das Abdichtungselement 15 kann beispielsweise ein über eine Öffnung 16 des Stehers 3 in den Hohlraum 11 eingespritzter aushärtbarer Dichtungsschaum sein; zur Formgebung des Dichtungsschaums während des Aushärtens zum Abdichtungselement 15 können beispielsweise aufblasbare Ballonstopfen temporär von unten und von oben in den Steher 3 eingebracht werden.

Alternativ kann das Abdichtungselement 15 schon während des Zusammenbaus bzw. der Montage des Stehers 3 eingebaut werden, z.B. in Form einer in diesen eingesteckten, eingeklebten, eingeschraubten oder eingeschweißten Trennwand. Eine weitere Möglichkeit ist es, ein Abdichtungselement 15 in Form eines elastischen Dichtstopfens von einem der Enden des Stehers 3 in diesen einzubringen. Sofern keine statischen Gründe dagegen sprechen, könnte in einer einfachen Variante auch eine Trennwand durch einen entsprechenden Schlitz in den Steher 3 eingeschoben werden, um das Abdichtungselement 15 zu bilden.

Im Betrieb nimmt die durch den Kamineffekt im Steher 3 aufsteigende Luftsäule einen Umweg über die Strömungsverbindung 12 zum Schaltschrank 8 und über die Strömungsverbindung 13 zurück zum Steher 3, siehe Pfeile 17, 18. Selbst wenn diese Luftsäule aufgrund der Erwärmung im Hohlraum 11 des Stehers 3 erhöhte Temperatur hat, ist die über den Lufteinlaß 9 zuströmende Außenluft von geringerer Temperatur als das Innere 14 des Schaltschranks 8, sodaß dieser gekühlt wird. Je weiter unten der Schaltschrank 8 daher am Steher 3 montiert wird, desto geringer ist die Erwärmung der Luftsäule im Steher 3 vor ihrem Eintritt in den Schaltschrank 8 und umso besser ist die Kühlungswirkung.

Falls gewünscht, kann im Inneren des Schaltschranks 8 zusätzlich ein Ventilator 19 zur Luftverteilung bzw. Förderung der Konvektion angeordnet werden, ebenso z.B. am Luftauslaß 10 des Stehers 3 ein Abzugsventilator 20.

Die Erfindung ist nicht auf die dargestellten Ausführungsformen beschränkt, sondern umfaßt alle Varianten und Modifikationen, die in den Rahmen der angeschlossenen Ansprüche fallen. So kann der zur Kühlung des Schaltschranks 8 herangezogene Steher 3 auch von anderer Art sein, beispielsweise ein Antennenmast, ein Dach- oder Fassadenträger eines Bauwerks usw. Die im Schaltschrank 8 enthaltenen elektronischen Komponenten können darin auch nochmals in einem eigenen Innengehäuse beherbergt sein, wobei dann der Zwischenraum zwischen dem Schaltschrank 8 und dem Innengehäuse das luftdurchströmte Innere 14 bilden.

## Patentansprüche

1. Vorrichtung zur Kühlung eines Schaltschranks, mit einem hohlen Steher (3) wie einem Mast, einem Brückenpfeiler, einem Träger usw., der einen Lufteinlaß (9) an seinem unteren und einen Luftauslaß (10) an seinem oberen Ende aufweist und den Schaltschrank (8) an seiner Seite trägt, wobei auf Höhe des unteren und des oberen Endes des Schaltschranks (8) jeweils eine Strömungsverbindung (12, 13) zwischen dem Inneren (14) des Schaltschranks (8) und dem Hohlraum (11) des Stehers (3) hergestellt und der Hohlraum (11) des Stehers (3) auf Höhe zwischen den beiden Strömungsverbindungen (12, 13) durch ein Abdichtungselement (15) blockiert ist.

2. Vorrichtung nach Anspruch 1, **dadurch gekennzeichnet, daß** der Steher (3) ein Stahlsteher einer eine Straße überspannenden Brücke (1) und sein Lufteinlaß (9) eine Kondenswasser-Ablauföffnung am unteren Ende des Stahlstehers ist.

3. Vorrichtung nach Anspruch 1 oder 2, **dadurch gekennzeichnet, daß** das Abdichtungselement (15) ein in den Hohlraum (11) eingespritzter, aushärtbarer Dichtungsschaum ist.

4. Vorrichtung nach einem der Ansprüche 1 bis 3, **dadurch gekennzeichnet, daß** der Schaltschrank (8) zusätzlich mit einem Ventilator (19) zur Zwangskonvektion ausgestattet ist.

5. Vorrichtung nach einem der Ansprüche 1 bis 4, **dadurch gekennzeichnet, daß** der Luftauslaß (10) des Stehers (3) zusätzlich mit einem Abzugsventilator (20) versehen ist.

## Claims

1. Device for cooling an electrical cabinet, with a hollow upright beam such as a mast, bridge pillar, girder etc., which upright beam has an air inlet (9) at its lower end and an air outlet (10) at its upper end and bears the electrical cabinet (8) on its side, wherein at the levels of the lower end and the upper end of the electrical cabinet (8) a flow connection (12, 13) is respectively created between the interior (14) of the electrical cabinet (8) and the cavity (11) of the upright beam (3), and the cavity (11) of the upright beam (3) is blocked by a sealing element (15) at a level between the two flow connections (12, 13).

2. Device according to claim 1, **characterised in that** the upright beam (3) is a steel upright of a bridge (1) spanning a road and its air inlet (9) is a discharge opening for condensate at the lower end of the steel upright.

3. Device according to claim 1 or 2, **characterised in that** the sealing element (15) is a curable sealing foam injected into the cavity (11).

4. Device according to one of claims 1 to 3, **characterised in that** the electrical cabinet (8) is additionally fitted with a fan (19) for forced convection.

5. Device according to one of claims 1 to 4, **characterised in that** the air outlet (10) of the upright beam (3) is additionally provided with an extractor fan (20).

## Revendications

1. Dispositif destiné au refroidissement d'une armoire électrique, comportant un montant (3) creux, tel qu'un poteau, une pile de pont, un support, etc., qui présente une entrée d'air (9) au niveau de son extrémité inférieure et une sortie d'air (10) au niveau de son extrémité supérieure et qui supporte au niveau de son côté l'armoire électrique (8), sachant qu'à hauteur de l'extrémité inférieure et de l'extrémité supérieure de l'armoire électrique (8) est établie respectivement une liaison fluidique (12, 13) entre l'intérieur (14) de l'armoire électrique (8) et l'espace creux (11) du montant (3) et que l'espace creux (11) du montant (3) est bloqué à hauteur entre les deux liaisons fluidiques (12, 13) par un élément d'étanchéification (15).

2. Dispositif selon la revendication 1, **caractérisé en ce que** le montant (3) est un montant en acier d'un pont (1) suspendu au-dessus d'une route, et **en ce que** son entrée d'air (9) est un orifice d'évacuation d'eau de condensation au niveau de l'extrémité inférieure du montant en acier.

3. Dispositif selon la revendication 1 ou 2, **caractérisé en ce que** l'élément d'étanchéification (15) est une mousse d'étanchéité injectée dans l'espace creux (11), durcissable.

4. Dispositif selon l'une quelconque des revendications 1 à 3, **caractérisé en ce que** l'armoire électrique (8) est équipée en complément d'un ventilateur (19) servant à la convection forcée.

5. Dispositif selon l'une quelconque des revendications 1 à 4, **caractérisé en ce que** la sortie d'air (10) du montant (3) est pourvue en complément d'un ventilateur d'extraction (20).
